# EUROPEAN PATENT SPECIFICATION

(11) **EP 4 407 675 B1**
(45) Date of publication and mention of the grant of the patent: **13.08.2025**
(21) Application number: 23153311.8
(22) Date of filing: 25.01.2023
(51) Int. Cl.: H01L 23/40, H01L 23/367

(54) **AN ADJUSTABLE HEAT SPREADER FOR A HEAT SINK**
VERSTELLBARER WÄRMEVERTEILER FÜR EINEN KÜHLKÖRPER
DIFFUSEUR DE CHALEUR RÉGLABLE POUR DISSIPATEUR THERMIQUE

(43) Date of publication of application: 31.07.2024
(73) Proprietor: Aptiv Technologies AG, 8200 Schaffhausen (CH)
(72) Inventor: RADEMACHER, Falk, 2 Dublin (IE); REINHOLD, Peter, 2 Dublin (IE)
(74) Representative: Lewis Silkin LLP

(56) References cited:
- US-A1- 2022 377 945

## Description

### Introduction

The present disclosure relates to a heat sink for electronic components, particularly an adjustable heat dissipating insert (i.e. heat spreader) for a heat sink system associated with the printed circuit board. The invention has particular application in the automotive field where electronic control units (ECUs) are deployed.

### Background

Many electronic components, such as integrated circuits (ICs) on a printed circuit board (PCB), generate thermal energy (i.e. heat). If this heat is not sufficiently transferred away, it can cause damage/failure to the component itself or neighbouring components.

Heat sinks are commonly used to connect to integrated circuits and the like for the purpose of transferring thermal energy to the mass of the heat sink itself and/or to a movable medium such as air or a fluid medium like water flowing within a closed circuit. The heat sink and its medium transfers the thermal energy to areas with lower thermal energy, there the heat will be exchanged out of system.

Due to various manufacturing tolerances, a heat sink will have an unavoidable physical gap with the integrated circuit, which is typically filled by a thermal interface material (TIM). The thermal efficiency of a heat sink system is strongly dependent on this thermal interface: since the smaller the mechanical gap, the higher the thermal efficiency.

EP4092720A1 describes a heat sink non-adjustably mounted on a support surface with an insert that has direct contact to a transfer media. The insert is adjusted toward and away from the component to minimise a thickness of the layer of TIM material.

### Summary

In light of the above, the present invention seeks to propose an improvement, particularly a solution that may enable an easily adjustable heat sink with a layer of TIM applied as thinly as possible to the top of the integrated circuit or any other comparable thermal heat source.

A first aspect of the invention is outlined according to claim 1 of the appended claims. Broadly, a heat sink system may comprise a mount for mounting to a circuit board or like structure accommodating one or more electronic components. An insert (i.e. a heat spreader) is provided for adjustable positioning within an opening through the mount, such that the insert is movable toward and away from the circuit board/component in use. In this way, a contact surface of the insert is able to be brought into contact with a component to be cooled upon the circuit board (or at least in contact with a thin layer of TIM sandwiched between the insert and the component). The mount or mounting element, generally referred to herein as a "housing", is configured with a first, e.g. circuit facing, surface and a second, e.g. heat sink facing, surface. The circuit facing surface may include fastening features to attach a circuit board thereto. The housing may be thermally conductive, e.g. of metal, but this is not essential since the primary heat transfer path is from the component to be cooled, through the heat spreading insert, and into the heat sink. The housing/mount may be formed from plastic, which is particularly distinct from a heat sink.

In this way, a mechanically separated heat sink may be attached to the mount that houses the adjustable insert such that a separable/exchangeable heat sink is positionable proximate thereto and, particularly, any fluid path for a cooling medium within the heat sink is partitioned from the adjustable insert. Such a construction allows the heat sink to be separable from the mounting element to enable access to the insert for adjustment or removal/exchange, in turn allowing access to the component to be cooled for inspection and/or replacement.

The term "heat spreader" used herein in relation to the insert refers to the function of transferring heat from a small, concentrated point (e.g. on an electronic component) and decreasing the power density. The heat spreader is a means of transferring heat between an object to be cooled and a substantive heat sink.

In a preferred form, the invention is configured to enable a thinnest layer of TIM on the component facing side of the heat spreader, e.g. 0 - 0.2mm thickness, compared to (if necessary) a thicker TIM layer on the opposite, heat sink facing, side of the heat spreader, e.g. 1-2mm. The second layer may therefore be tenfold thicker than the component layer side. This is acceptable because the power density has already decreased through the insert.

Various types of thermal interface material are possible and are not limited herein. For example, the TIM layer may be in the form of paste, adhesive, gap filler, a pad, tape or phase change materials.

A further expression of the invention may be phrased as a mounting body for attachment to a support surface provided with at least one component to be cooled, wherein the mounting body comprises at least one insert that is adjustably mounted in the body (e.g. within an opening therethrough) so that an insert contact surface is, in use, displaceable (e.g. moveably adjustable) relative to the component to be cooled, and further comprising a heat sink contact surface for interfacing with a separable heat sink structure. In this way, a minimum thickness of TIM can be applied between the component to be cooled and the insert, while enabling removal of a separate heat sink structure to provide access to the insert. A heat sink system of the invention may comprise a combination of the mounting body with adjustable insert and a separable heat sink, e.g. which includes a cooling medium fluid path therewithin.

In one form, the insert is adjustable along an axis of movement that is perpendicular to a contact surface of the component or element to be cooled. In this way, the insert is adjustable toward and away from the component to close any gap that is to be filled with TIM. Displacement/adjustability may also be lateral, e.g. where the insert slides within the opening which functions as a track. Adjustability may be both vertical (y-axis) and lateral (x- and/or z-axis) or one or the other. In this way, fine adjustments can be made to ensure that the insert is optimally positioned upon the surface of the component to be cooled.

In one form, the insert is adjustably fitted into the mounting body by means of a first threaded part of the insert engageable with a second threaded part of the body. The first threaded part may be located at a periphery of the insert and the opening through the body comprises the second threaded part. In this way a vertical displacement, relative to the support surface/component, of the insert is possible.

In alternate forms the insert may be adjustably fitted into the body by means of a push-fit inter-engagement. In this form, the inter-engagement between the body and the insert involves a periphery of the insert and an internal wall of the opening.

A further alternative or additional form may comprise an adhesive or sealant between the insert and the opening. The sealant may be a thread sealant or a thread lock. Sealing may comprise an O-ring, preferably protruding at a periphery of the insert.

Alternatively, for adjustment and fixing, the material connections may also be achieved by soldering or welding.

In one form, the insert may be adjustably moveable by being configured for sliding laterally within the opening, which is an elongate opening; and/or engagement between a receiving portion and a guide element. In this way, lateral movement can be controlled for accurate positioning. This slidable aspect of the invention is applicable more generally to an integrated heat sink design such as described by EP4092720A1. In other words, in one aspect, a heat sink comprising a body non-adjustably mountable on a support provided with at least one element to be cooled, wherein the body comprises at least one insert that is slidably fitted therein so that an insert contact surface comes into contact with the element to be cooled and is laterally adjustable relative thereto. All aspects relating to the sliding aspect described herein (such as a dovetail track) are independently applicable to a heat sink of the type described by EP4092720A1. In this way, a slidable insert structure is possible that does not necessarily require a separable heat sink as described herein.

Accordingly, as above, the insert may be adjustably fitted into the body for thermally communicating with the component to be cooled via a first layer of a thermal interface material.

In one form, the heat sink contact (or facing) surface is provided with a (second) layer of TIM, i.e. to interface with a heat sink. A surface of the insert, opposite to the component contact surface, may also comprise a layer of TIM when assembled for use.

In one form, the insert further comprises a gripping means or features for assisting the insert to be adjusted within the body opening. The gripping means/features may comprise at least one bore, e.g. a blind bore, for receiving a tool. The at least one bore may be formed in the surface of the insert, e.g. opposite to the component contact surface. The insert may include alternative or additional gripping/keyed features.

In a further aspect of the invention, a printed circuit board is provided as the support surface, non-adjustably mounted in combination with the mounting body.

In a further aspect, a vehicle may comprise the heat sink, in combination with the printed circuit board and mounting body.

The invention is applicable not only to automotive applications, but to any field where a heat sink is required to be mounted to an electronic component needing heat dissipation.

### Brief Description of Drawings

Illustrative embodiments will now be described with reference to the accompanying drawings in which:
Figure 1 illustrates a side elevation section view of a first embodiment of the invention, in place with respect to a component to be cooled;
Figure 2 illustrates the embodiment of Figure 1, in place with respect to a different component to be cooled;
Figure 3 illustrates a pictorial section view of the first embodiment;
Figure 4 illustrates a pictorial section view of a second embodiment;
Figure 5 illustrates a pictorial section view of an alternative heat sink structure; and
Figure 6 illustrates a pictorial section view of a third embodiment.

### Detailed Description

The following description presents exemplary embodiments and, together with the drawings, serves to explain principles of the invention. Terms for components used herein should be given a broad interpretation that also encompasses equivalent functions and features. In some cases, several alternative terms (synonyms) for structural features have been provided but such terms are not intended to be exhaustive. Descriptive terms should also be given the broadest possible interpretation; e.g. the term "comprising" as used in this specification means "consisting at least in part of" such that interpreting each statement in this specification that includes the term "comprising", features other than that, in addition to, or those prefaced by the term may also be present. Related terms such as "comprise" and "comprises" are to be interpreted in the same manner. Directional terms such as "vertical", "horizontal", "up", "down", "sideways", "upper" and "lower" are used for convenience of explanation usually with reference to the orientation shown in illustrations and are not intended to be ultimately limiting if an equivalent function can be achieved with an alternative dimension and/or direction. Therefore, all directional terms are merely relative to each other.

The description herein refers to embodiments with particular combinations of steps or features, however, it is envisaged that further combinations and cross-combinations of compatible steps or features between embodiments will be possible. Indeed, isolated features may function independently as an invention from other features and not necessarily require implementation as a complete combination.

It will be understood that the illustrated embodiments show applications only for the purposes of explanation. In practice, the invention may be applied to many different configurations, where the embodiment is straightforward for those skilled in the art to implement.

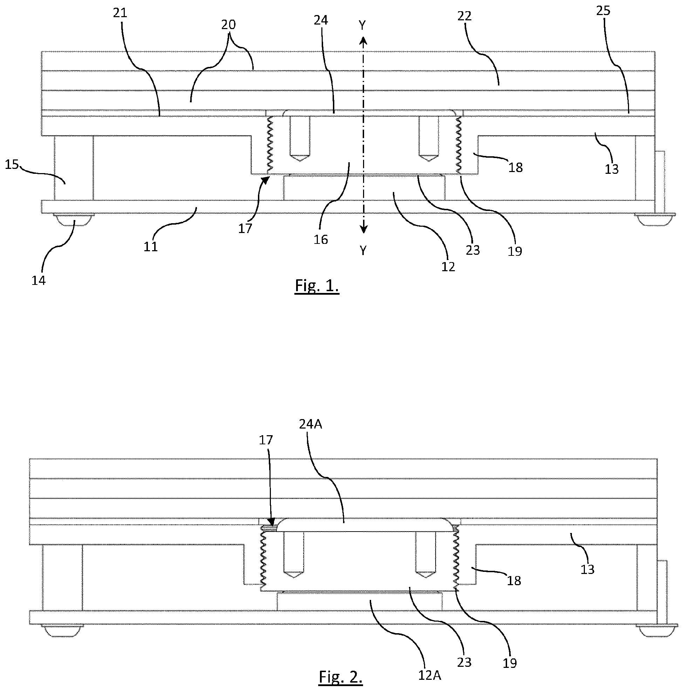

Figure 1 illustrates a cross section view of a circuit board 11 having an integrated circuit/component 12 upon its surface. The circuit board 11 is a support surface for the component 12 and is also fastened to a mounting body, e.g. housing 13, which serves to provide a mounting structure substantially over/above component 12. The housing is generally fastened, e.g. by a screw 14 into support legs 15, to circuit board 11 in a non-adjustable (in use) spatial relationship.

Integrated as a feature of the housing/mount 13 is an adjustable heat dissipation device or insert 16, configured to adjustably move relative to component 12, e.g. toward and away from it along an axis A. Insert 16 is located within an opening/bore 17 through body 13, that may include upstanding walls 18 to give it additional depth than the substantive planar thickness of body 13.

In this first illustrated example, spatial adjustment relative to component 12 is by virtue of a screw thread engagement 19 between a peripheral wall of insert 16 and housing 13 / walls 18. In this way, insert 16 is a block of thermally transmittive material (e.g. made from any solid high thermal conductive material like aluminium, copper or ceramic) that can convey heat generated by the component 12 away from it and toward the mounting body 13 and a separate heat sink structure 20. The mounting body 13 comprises a heat sink facing surface 21 that is in close contact but separable from the heat sink structure 20. Common heat sink features such as a coolant path 22 are provided within the heat sink structure 20. However, as is apparent from the figures, the coolant path 22 is partitioned from the mounting body and insert. In this way, separating the heat sink 20 from the mounting body and circuit does not result in leakage or other compromise of the cooling medium.

In preparation for use, sandwiched between a top side of integrated circuit 12 (which is the thermal heat source in the present example) and the heat dissipating insert 16 is a first layer of thermal interface material (TIM) 23.

The insert 16 can be spatially re-configured relative to component 12, e.g. height adjusted along axis Y, so that the TIM layer 23 can be applied as thinly as possible to cover the top side of the integrated circuit 12 in good thermal contact. Generally, it is understood that the thermal interface material is not as thermally efficient at conveying heat as the rest of a heat sink structure.

An opposite surface of the heat spreader insert 16, distant from component 12, is covered with a second TIM layer 24 while the mechanically separated heat sink 20 is contacted to that second layer of TIM 24. Thus, via two TIM layers 23/24 and the insert 16, the heat sink 20 is ultimately in thermal communication with component 12.

In the illustrated form, a substantive outer surface 21 of housing 13 may also be covered in a TIM 25 on the same plane as TIM layer 24, for substantive contact against heat sink 20; however, it is contact in the vicinity of the insert 16 and component 12 which is most critical such that a cooling fluid within channel 22 of heat sink 20 can ultimately remove heat from component 12.

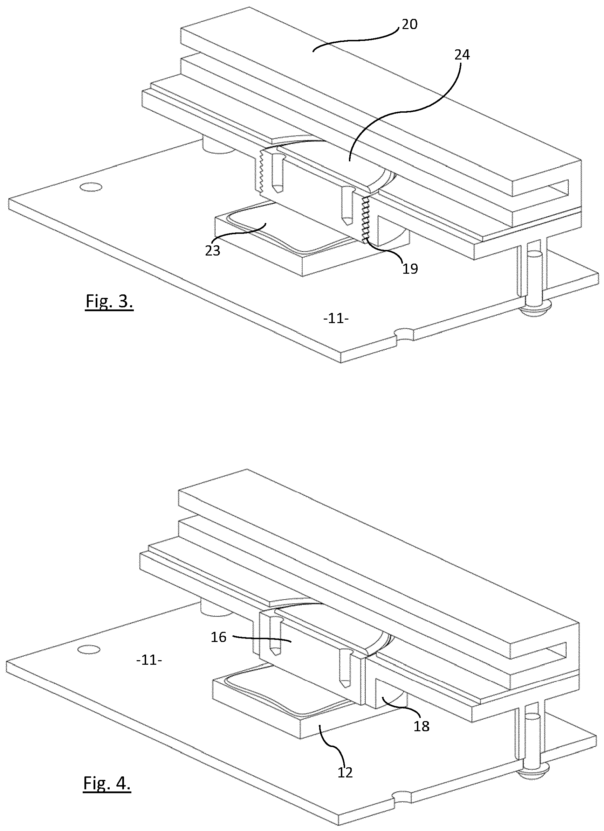

An adjustment and fixing configuration for the heat spreader device 16 can be implemented in a form fitting way, e.g. a threaded connection between insert 16 and housing 13 as shown in Figures 1 to 3, or a press fit or adhesive solution as shown in Figure 4. Other material connections are possible such as soldering/welding, once the relative height of insert 16 to minimise the TIM contact gap 23 is set.

The heat spreader 16 can be made of any solid high thermal conductive material, such as aluminium, copper or ceramic.

The heat sink 20 may include a closed circuit for a transfer media and/or a solid part, such as cooling fins or a section of a car chassis.

While Figure 1 shows a configuration of the invention adapted to thermally contact with a relatively high component 12, Figure 2 shows the same embodiment, but configured to thermally contact with a more shallow component 12A. The other components are otherwise the same.

According to Figure 2, insert 16 protrudes from mounting body 13/walls 18 by virtue of several turns of screw thread 19. In this way, the same thin layer of TIM 23 can be maintained against lower component 12A. As a result, the second layer of TIM may be thicker than that of Figure 1, denoted by numeral 24A. The fact that TIM layer 24A is thicker is relatively inconsequential since heat spreader 16 has already acted to reduce thermal density. TIM layer 24A is efficient enough to transfer heat to the substantive heat sink 20 and an associated cooling medium.

Figure 3 illustrates a perspective section view of the configuration from Figure 1, where adjustment thread 19 is visible, whereas Figure 4 illustrates a variant embodiment where insert 16 may be configured for adjustment by an interference fit (i.e. tight fit between its peripheral walls and inner walls 18 of mounting body 13.

Alternatively to an interference fit, insert 16 may be glued or soldered/welded in place.

In all cases, insert 16 is spatially adjusted relative to an object to be cooled on a supporting surface 11, preferably to achieve a layer of TIM 23 as thin as possible, while the opposite side of insert 16 maintains adequate thermal contact with a separable heat sink structure 20.

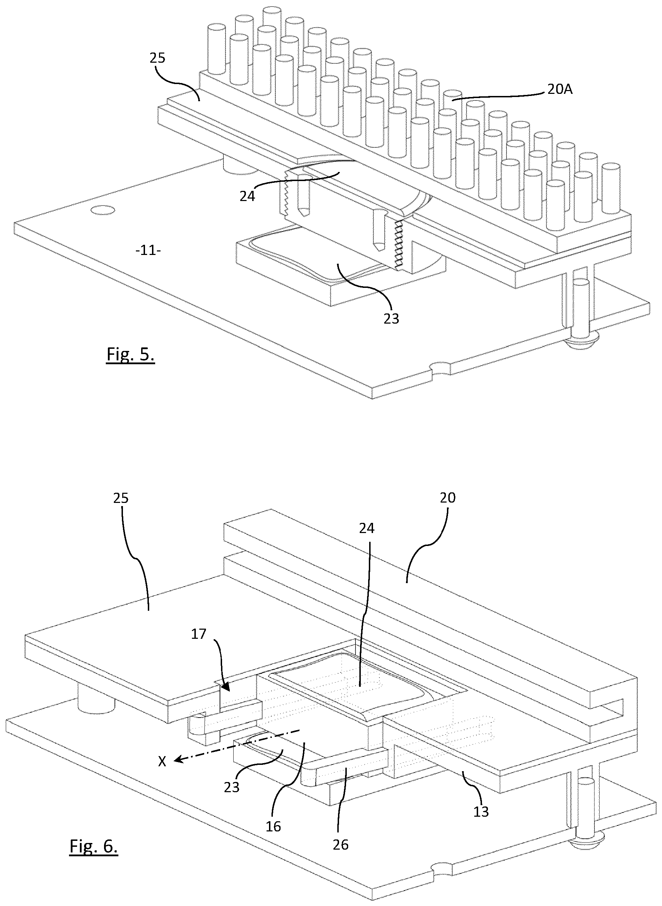

Figure 5 illustrates the adjustable heat spreader embodiment of Figures 1, 2 and 3, where an alternative separable heat sink structure 20A is thermally contacted, via TIM layers 24 and 25, with the insert and mounting body respectively. Heat sink 20A has surface features such as pins/fins for interacting with a cooling medium, e.g. air. However, the functionality of adjusting insert 16 relative to its mount 13, in order to minimise (or eliminate) TIM layer 23, is unchanged.

In all cases it will be apparent that heat sink 20/20A can be separated from mounting body 13 in order to access insert 16. Insert 16 can likewise be removed to gain access to component 12 underneath. The heat sink 20/20A may be attached by any suitable means to fix it in place, including use of the TIM as an adhesive that holds the components together. In this respect, in some embodiments a thermal interface material may provide an adhesive aspect to peripheral walls of the insert in contact with the opening, with or without a thread present.

By way of overview, the invention entails a dissipater or a heat spreader insert 16 mounted for adjustable movement from a frame support 13 fixed over a support surface 11 having an element 12 to be cooled. The element to be cooled may also be regarded as a heating element which is preferably immovable with respect to its support 11. The element to be cooled may typically be a chip, a chipset, an integrated circuit (IC), a central processing unit (CPU) or any other semiconductor. It should be noted that the element to be cooled is not limited to an electronic component but may also be an electrical element such as a transformer for example. The support 11 may be a plate or any element to be assembled relative to a heat sink 20. Preferably, the support 11 is a printed circuit board (PCB). It may relate to a PCB of an electronic control unit (ECU), more particularly a PCB belonging to a vehicle's ECU for instance.

The terms "support" and "mount" etc should be maintained, irrespective of the relative sizes of the components. Particularly, the main role of the support 11 is to be assembled to the heat sink 20, via the mounting body, in order to cool the heating element(s) 12 that the support 11 includes. The aforementioned support may also be considered to have been so named in reference to the at least one element 12 to be cooled that it carries.

Furthermore, the present heat sink system is not limited to have a single insert 16 but may include several inserts 16 adjustable from the mounting body 13, relative to a separable heat sink, which can be each adjusted independently from the others. Therefore, if the same support 11 has several elements 12 to be cooled which have elements contact surfaces protruding at different heights above the support 11, the present invention has the ability to adapt to each of the elements 12 of the support 11. In other words, the heat dissipation structure of the present disclosure is particularly efficient, not only with a support 11 comprising a single component 12 to be cooled, but also with a support 11 comprising a plurality of elements 12(12A), even if those or a part of them protrude at different levels above the support.

Although the insert 16 is preferably adjustable along an axis of movement Y-Y that is orthogonal to the support surface 11, more specifically perpendicular, it should be noted that the insert 16 could be adjustable according to an angled movement, for example using inclined sliding grooves arranged within the body 13. In such a case, the insert 16 may be provided with protrusions intended to engage the grooves of the body 13. A dovetail profile assembly (inclined e.g. at an acute angle relative to the planar surface of the support 11) may be used for example to move the insert 16 into the body 13, until the insert 16 comes into contact with the element 12 to be cooled or comes close to it. In such an embodiment, it should be noted that the insert 16 may have a shape which is not circular, when seen from above (e.g. in a direction according to the axis Y-Y of Fig. 1 ). Such a shape may be a square or rectangular shape for instance. Indeed, the insert 16 may be of non-circular shape in any embodiment that does not require a thread for rotational purposes.

A third embodiment of heat spreader configuration is illustrated by Figure 6. In this example, the opening 17 through the mounting body 13 may be oversized so as to accommodate lateral movement of the insert 16, e.g. in a direction X. In this way insert 16 may be engaged to move over (e.g. horizontally) the surface of component 12 instead of or in addition to movement toward and away (e.g. vertically along direct Y as shown in Figure 1) from component 12 as previously described.

The mechanism by which lateral movement is adjustable according to the illustration is a dovetail guide element 26. In other words, a pair of rails upon which the insert may engage and slide, although other solutions are possible. The mechanism generally features engagement between a receiving portion and a guide element. Indeed, in one form, insert 16 may be relatively free moving (e.g. in an X or Z direction) within an oversized opening 17 since it is clamped in place by heat sink 20 once fixed in position. In one form, a receiving portion and guide element may be (additionally or in combination) arranged vertically or at an angle to provide displacement relative to the fixed component.

In the illustrated form of Figure 6, opening 17 is generally rectangular with a width dimension to tightly accommodate insert 16, and a longer length, which serves as a track for controlled lateral movement of insert 16. Further forms may provide other mechanisms for controlling/constraining lateral and/or vertical movement of an insert 16 within a mounting body 13 relative to a component 12 to be cooled.

According to alternative or additional features/embodiments, the mounting body 13 may further include a sealing means between the insert 16 and walls of its opening 17, especially if adjustably fitted into the body by means of a push-fit inter-engagement.

In one embodiment, the sealing means is a threaded sealant or a thread lock.

According to another embodiment, the sealing means may be an O-ring. Preferably, such an O-ring is intended to protrude at the periphery of the insert 16. Whatever its embodiment, the sealing means may also prevent any accidental displacement of the insert 16 within the body 13 which may result from vibrations for example. Besides, the sealing means may also be used to meet ingress protection class requirements, especially against the ingress of dust and/or liquid. Alternatively, as already mentioned, a glue connection may be arranged between the insert 16 and the body 13/18, instead of or in addition to sealing. Such a glue connection may fixedly position the insert 16 within the body 13, once it has been properly adjusted with respect to the contact surface of the element to be cooled.

As described herein, the thermal interface material may be regarded as a gap filler which is mainly used to compensate any flatness deviation of the element contact surface and/or any possible defects between the respective contact surfaces. In addition or instead of the above functions, the thermal interface material can also play an adhesive role for assembling the two aforementioned contact surfaces. In any event, due to its thermal conductivity properties, the thermal interface material (23, 24, 25) helps to eliminate any remaining interstitial air gaps between respective contact surfaces and helps to evacuate the heat emitted by the heating element 12. The thermal interface material may typically consist of a gel, glue, a pad, an adhesive tape or thermal grease for example.

The insert 16 and heat sink 20 may be made of any suitable thermally conductive material such as aluminium, copper or a combination of any materials for example.

By way of summary, an adjustable heat spreader is described herein which comprises a mounting body for mounting to a circuit board having at least one electronic component to be cooled. The mounting body includes an opening into which is fitted a heat spreading insert. In use, a contact surface of the insert is able to be brought into contact against the component. The mounting body also has a contact surface provided for interfacing with a mechanically separate heat sink. A layer of thermal interface material may be applied between the insert and the component, the insert and the heat sink and the mounting body and the heat sink.

The present disclosure further relates to a printed circuit board 11 in combination with a mounting body 13, non-adjustably mounted together.

Finally, the present disclosure further relates to a vehicle, in particular a motor vehicle, comprising the aforementioned printed circuit board in combination with the mounting body and its adjustable insert. The vehicle body itself may serve as a separable heat sink.

## Claims

1. An adjustable heat spreader, comprising:
a mounting body (13) for mounting to a support surface (11) having at least one element (12) to be cooled;
at least one heat spreading insert (16) adjustably fitted with the mounting body (13) so that an insert contact surface is brought into contact with the element (12) to be cooled;
wherein the mounting body (13) comprises a mount contact surface (21) configured for interfacing with a separable heat sink (20).

2. The adjustable heat spreader of claim 1, wherein said insert (16) is adjustable along an axis of movement (Y) that is perpendicular and/or lateral to an element contact surface of the element (12) to be cooled.

3. The adjustable heat spreader of claim 1 or 2, wherein the insert (16) is adjustably fitted into an opening (17) through the mounting body (13).

4. The adjustable heat spreader of claim 3, wherein the insert (16) is adjustably moveable by means of either:
a first threaded part (19) of the periphery of the insert which engages with a second threaded part of the opening (17);
a push-fit inter-engagement;
a seal between the insert and the opening;
an O-ring, protruding at a periphery of the insert (16);
an adhesive between a periphery of the insert and the opening (17);
slidable lateral movement within the opening (17) ;
a solder or weld between a periphery of the insert (16) and the opening (17);
or any combination of the above means.

5. The adjustable heat spreader of any preceding claim, wherein the mounting body (13) further comprises fastening features (14, 15) for fastening with the support surface (11) in a non-adjustable, in use, spatial relationship.

6. The adjustable heat spreader of any preceding claim, wherein the insert (16) further comprises a gripping means for assisting the insert (16) to be adjusted within the body relative to the support surface.

7. The adjustable heat spreader of any preceding claim, wherein there are at least two adjustable heat spreading inserts (16) each adjustably fitted with the mounting body (13) so that a respective insert contact surface is able to be brought towards contact with a respective element (12) to be cooled.

8. A heat sink system comprising an adjustable heat spreader according to any preceding claim, in combination with a heat sink (20) fitted against the mount contact surface (21), wherein the insert (16) is adjustably fitted to contact at the insert contact surface with the at least one element (12) to be cooled.

9. The heat sink system of claim 8, wherein contact is via a first layer (23) of thermal interface material.

10. The heat sink system of claim 8 or 9, wherein a second layer (24) of thermal interface material is applied at an opposite side of the insert (16) from the insert contact surface, in proximity to or contacting the heat sink (20).

11. The heat sink system of claim 9 and 10, wherein the second layer (24) of thermal interface material is substantially thicker than the first layer (23) of thermal interface material.

12. The heat sink system of any preceding claim 8 to 11, wherein there is a layer (25) of thermal interface material between the heat sink (20) and the mount contact surface (13).

13. The heat sink system of any preceding claim 8 to 12, wherein the heat sink (20) is part of the body of a vehicle.

14. A printed circuit board in combination with an adjustable heat spreader according to any of claims 1 to 7 or a heat sink system according to any of claims 8 to 12, wherein the printed circuit board (11) is the support surface and the at least one element (12) to be cooled is an electronic component.

15. A vehicle in combination an adjustable heat spreader according to any of claims 1 to 7, wherein a portion of the body of the vehicle comprises the separable heat sink.

## Patentansprüche

1. Regelbarer Hitzeverteiler, umfassend:
Einen Montagekörper (13) für das Montieren auf einer Auflagefläche (11) mit mindestens einem zu kühlenden Element (12);
mindestens einen hitzeverteilenden Einsatz (16), der regelbar in den Montagekörper (13) eingepasst ist, so dass eine Einsatz-Kontaktfläche in Kontakt mit dem zu kühlenden Element (12) gebracht wird;
wobei der Montagekörper (13) eine Montage-Kontaktfläche (21) umfasst, die so konfiguriert ist, dass sie mit einem trennbaren Kühlkörper (20) gekoppelt ist.

2. Regelbarer Hitzeverteiler nach Anspruch 1, wobei der Einsatz (16) entlang einer Bewegungsachse (Y) regelbar ist, die senkrecht und/oder seitlich zu einer Element-Kontaktfläche des zu kühlenden Elements (12) verläuft.

3. Regelbarer Hitzeverteiler nach Anspruch 1 oder 2, wobei der Einsatz (16) regelbar in eine Öffnung (17) durch den Montagekörper (13) eingepasst ist.

4. Regelbarer Hitzeverteiler nach Anspruch 3, wobei der Einsatz (16) über Folgendes regelbar beweglich ist:
Ein erstes Gewindeteil (19) des Umfangs des Einsatzes, das in ein zweites Gewindeteil der Öffnung (17) eingreift;
einen steckbaren Zwischen-Eingriff;
eine Dichtung zwischen dem Einsatz und der Öffnung;
einen O-Ring, der aus einem Umfang des Einsatzes (16) herausragt;
ein Haftmittel zwischen einem Umfang des Einsatzes und der Öffnung (17);
verschiebbare seitliche Bewegung innerhalb der Öffnung (17);
ein Lötmittel oder eine Schweißverbindung zwischen einem Umfang des Einsatzes (16) und der Öffnung (17);
oder jede Kombination der oben genannten Hilfsmittel.

5. Regelbarer Hitzeverteiler nach einem der vorstehenden Ansprüche, wobei der Montagekörper (13) ferner Befestigungsvorrichtungen (14, 15) zum Befestigen an der Auflagefläche (11) in einer im Einsatz nicht-regelbaren, räumlichen Beziehung umfasst.

6. Regelbarer Hitzeverteiler nach einem der vorstehenden Ansprüche, wobei der Einsatz (16) ferner eine Einspannvorrichtung zur Unterstützung der Verstellung des Einsatzes (16) innerhalb des Körpers relativ zur Auflagefläche umfasst.

7. Regelbarer Hitzeverteiler nach einem der vorstehenden Ansprüche, wobei mindestens zwei regelbare Hitzeverteiler-Einsätze (16) vorhanden sind, die jeweils regelbar in den Montagekörper (13) eingepasst sind, so dass eine entsprechende Einsatz-Kontaktfläche in Kontakt mit einem entsprechenden zu kühlenden Element (12) gebracht werden kann.

8. Kühlkörpersystem umfassend einen regelbaren Hitzeverteiler nach einem der vorstehenden Ansprüche, in Kombination mit einem Kühlkörper (20), der gegen die Montage-Kontaktfläche (21) eingepasst ist, wobei der Einsatz (16) regelbar eingepasst ist, um Kontakt an der Einsatz-Kontaktfläche mit dem mindestens einen zu kühlenden Element (12) herzustellen.

9. Kühlkörpersystem nach Anspruch 8, wobei Kontakt über eine erste Schicht (23) eines Wärmeleitmaterials besteht.

10. Kühlkörpersystem nach Anspruch 8 oder 9, wobei eine zweite Schicht (24) eines Wärmeleitmaterials auf eine gegenüberliegende Seite des Einsatzes (16) von der Einsatz-Kontaktfläche, in der Nähe oder in Kontakt mit dem Kühlkörper (20), angewendet wird.

11. Kühlkörpersystem nach Anspruch 9 und 10, wobei die zweite Schicht (24) des Wärmeleitmaterials im Wesentlichen dicker ist als die erste Schicht (23) des Wärmeleitmaterials.

12. Kühlkörpersystem nach einem der vorstehenden Ansprüche 8 bis 11, wobei eine Schicht (25) eines Wärmeleitmaterials zwischen dem Kühlkörper (20) und der Montage-Kontaktfläche (13) vorhanden ist.

13. Kühlkörpersystem nach einem der vorstehenden Ansprüche 8 bis 12, wobei der Kühlkörper (20) Teil der Karosserie eines Fahrzeugs ist.

14. Leiterplatte in Kombination mit einem regelbaren Hitzeverteiler nach einem der Ansprüche 1 bis 7 oder ein Kühlkörpersystem nach einem der Ansprüche 8 bis 12, wobei die Leiterplatte (11) die Auflagefläche und das mindestens eine zu kühlende Element (12) eine elektronische Komponente ist.

15. Fahrzeug in Kombination mit einem regelbaren Hitzeverteiler nach einem der Ansprüche 1 bis 7, wobei ein Abschnitt der Fahrzeugkarosserie den trennbaren Kühlkörper umfasst.

## Revendications

1. Diffuseur de chaleur réglable, comprenant :
un corps de montage (13) destiné à être monté sur une surface de support (11) présentant au moins un élément (12) à refroidir ;
au moins un insert de diffusion de chaleur (16) ajusté de manière réglable au corps de montage (13) de manière à ce qu'une surface de contact de l'insert soit mise en contact avec l'élément à refroidir (12) ;
dans lequel le corps de montage (13) comprend une surface de contact de montage (21) conçue pour interfacer avec un dissipateur de chaleur séparable (20).

2. Diffuseur de chaleur réglable selon la revendication 1, dans lequel ledit insert (16) est réglable le long d'un axe de mouvement (Y) qui est perpendiculaire et/ou latéral à une surface de contact d'élément de l'élément (12) à refroidir.

3. Diffuseur de chaleur réglable selon la revendication 1 ou 2, dans lequel l'insert (16) est ajusté de manière réglable dans une ouverture (17) à travers le corps de montage (13).

4. Diffuseur de chaleur réglable selon la revendication 3, dans lequel l'insert (16) est déplaçable de manière réglable au moyen de l'un ou l'autre des éléments suivants :
une première partie filetée (19) de la périphérie de l'insert, qui s'engage dans une seconde partie filetée de l'ouverture (17) ;
un emboîtement par pression ;
un joint d'étanchéité entre l'insert et l'ouverture ;
un joint torique faisant saillie à la périphérie de l'insert (16) ;
un adhésif entre une périphérie de l'insert et l'ouverture (17) ;
un mouvement latéral coulissant à l'intérieur de l'ouverture (17) ;
une soudure ou une brasure entre une périphérie de l'insert (16) et l'ouverture (17) ;
ou toute association de moyens ci-dessus.

5. Diffuseur de chaleur réglable selon une quelconque des revendications précédentes, dans lequel le corps de montage (13) comprend en outre des caractéristiques de fixation (14, 15) destinées à la fixation avec la surface de support (11) dans une relation spatiale non réglable, lors de l'utilisation.

6. Diffuseur de chaleur réglable selon une quelconque des revendications précédentes, dans lequel l'insert (16) comprend en outre un moyen de préhension destiné à aider l'insert (16) à être réglé à l'intérieur du corps par rapport à la surface de support.

7. Diffuseur de chaleur réglable selon une quelconque des revendications précédentes, dans lequel il y a au moins deux inserts de diffusion de chaleur réglable (16), chacun étant ajusté de manière réglable avec le corps de montage (13) de manière à ce qu'une surface de contact d'insert respective puisse être amenée en contact avec un élément respectif (12) à refroidir.

8. Système de dissipateur de chaleur comprenant un diffuseur de chaleur réglable selon une quelconque des revendications précédentes, en association avec un dissipateur de chaleur (20) ajusté contre la surface de contact de montage (21), dans lequel l'insert (16) est ajusté de manière réglable pour entrer en contact au niveau de la surface de contact d'insert avec ledit au moins un élément (12) à refroidir.

9. Système de dissipateur de chaleur selon la revendication 8, dans lequel le contact se fait par l'intermédiaire d'une première couche (23) de matériau d'interface thermique.

10. Système de dissipateur de chaleur selon la revendication 8 ou 9, dans lequel une seconde couche (24) de matériau d'interface thermique est appliquée sur un côté opposé de l'insert (16) par rapport à la surface de contact de l'insert, à proximité du dissipateur de chaleur (20).

11. Système de dissipateur de chaleur selon les revendications 9 et 10, dans lequel la seconde couche (24) de matériau d'interface thermique est sensiblement plus épaisse que la première couche (23) de matériau d'interface thermique.

12. Système de dissipateur de chaleur selon une quelconque des revendication précédente 8 à 11, dans lequel il y a une couche (25) de matériau d'interface thermique entre le dissipateur de chaleur (20) et la surface de contact de montage (13).

13. Système de dissipateur de chaleur selon une quelconque des revendication précédente 8 à 12, dans lequel le dissipateur de chaleur (20) fait partie de la carrosserie d'un véhicule.

14. Carte de circuits imprimés en association avec un diffuseur de chaleur réglable selon l'une quelconque des revendications 1 à 7 ou un système de dissipateur de chaleur selon l'une quelconque des revendications 8 à 12, dans lequel la carte de circuits imprimés (11) est la surface de support et ledit au moins un élément (12) à refroidir est un composant électronique.

15. Véhicule en association avec un diffuseur de chaleur réglable selon l'une quelconque des revendications 1 à 7, dans lequel une partie de la carrosserie du véhicule comprend le dissipateur de chaleur séparable.
